Europäisches Patentamt

European Patent Office

Office européen des brevets

(19)

(11) Publication number: **0 001 164**
**B1**

(12) **EUROPEAN PATENT SPECIFICATION**

(45) Date of publication of patent specification: **06.01.82**

(21) Application number: **78300322.1**

(22) Date of filing: **25.08.78**

(51) Int. Cl.³: **G 11 C 17/00, H 01 L 27/02**

(54) Integrated read-only memory.

(30) Priority: **31.08.77 US  829570**

(43) Date of publication of application:
**21.03.79 Bulletin 79/6**

(45) Publication of the grant of the European patent:
**06.01.82 Bulletin 82/1**

(84) Designated Contracting States:
**BE DE FR GB NL SE**

(56) References cited:
GB - A - 981 104
GB - A - 1 300 301
GB - A - 1 348 361
US - A - 3 400 379
US - A - 3 541 543
US - A - 3 849 638
US - A - 3 936 812
US - A - 3 975 623
US - A - 3 987 287

(73) Proprietor: **Western Electric Company,
Incorporated
222 Broadway
New York N.Y. 10038 (US)**

(72) Inventor: **Blahut, Donald Edgar
9 Stevens Drive
Holmdel New Jersey 07733 (US)**
Inventor: **Cooper.Jr., James Albert
32 Northfield Road
Millington New Jersey 07946 (US)**

(74) Representative: **Watts, Christopher Malcolm
Kelway, Dr. et al,
Western Electric Company Limited 5, Mornington
Road
Woodford Green Essex, IG8 0TU (GB)**

(56) References cited:
IBM TECHNICAL DISCLOSURE BULLETIN,
vol. 15, no. 8, January 1973,
Armonk (USA).
FLEISHER et al "Use of Split
Decoders to Improve Efficiency of
Multiperpose Array Logic",
pages 2510—2511.

Courier Press, Leamington Spa, England.

(56) References cited:
**IBM TECHNICAL DISCLOSURE BULLETIN,**
*vol. 19, no. 6, November 1976,*
**Armonk (USA).**
**BALASUBRAMANIAM et al. "Program**
**Logic Array with Metal Level**
**Personalization", pages 2144—2145.**

**NEUES AUS DER TECHNIK, no. 2,**
**1 April 1975,**
**Würzburg (DE)**
**"Festwertspeicher", page 4.**

Integrated read-only memory

This invention relates to semi-conductor integrated circuit read-only memories including a set of input (x) conductors and a set of output (y) conductors arranged to define an array of cross points, each of the cross points being formed by one input conductor and one output conductor and elements associated with selected ones of the cross points to provide predetermined patterns of binary signals on the output conductors in response to signals on respective ones of the input conductors, the presence of an element associated with a cross point being representative of a stored binary digit of one kind and the absence of an element associated with a cross point being representative of a stored binary digit of the said opposite kind.

Such a memory is known, for example, from "Neues aus der Technik", Nr. 2, 1st April 1975, page 4. In this memory one set of conductors consists of buried semi-conductor regions and the other consists of metallic conductors. The elements are vertical bipolar transistors.

In U.S. patent 3 849 638 there is disclosed a logic array in which row and/or column conductors are segmented so that different segments of a row or column can be used independently, for example to implement more than one logic function in a single column or row.

In one common type of ROM, the $y$ conductors, hereinafter designated "bit conductors", are alternated with electrically conducting ground lines formed at the same level. Information is stored permanently in such a memory, for example, by forming a switchable short circuit between a selected $y$ conductor and a ground line, switched via an $x$ conductor at a bit location at the intersection of the respective $x$ and $y$ conductors. Switching is accomplished by a short-circuit element which comprises, for example, an N-channel MOS device with a gate accessed via the $x$ conductor.

In this type of arrangement, it is common for each bit conductor to be connected to a drain electrode of, for example, a P-channel MOS device, the source of which is connected to a supply voltage $V_{DD}$. The gates of the P-channel devices similarly are connected electrically in parallel to a source of signals $\phi$. The ground lines are connected electrically in parallel to the drain of a common N-channel MOS device, the source of which is connected to ground. Clocking signals $\phi$ also are applied to the gate of the common N-channel device. Thus, when the P-channel devices are activated, the common N-channel device is deactivated and vice versa. Information is stored permanently in such an arrangement by connecting a bit conductor electrically to the next adjacent ground line at a prescribed cross point between the bit conductor and the intersecting $x$ conductor, connection being made through the short-circuit element as described above.

Thus, the stored information of the ROM is defined by digital ones and zeros permanently stored at the crosspoints or intersections of the $y$ and $x$ conductors. Each zero is defined by a short-circuit element connected between the $y$ conductor and a ground (or reference potential) conductor, and a one is defined by an open circuit, or no connection between the $y$ conductor and ground.

In the illustrative example described hereinafter, the ROM is word organised and, accordingly, the $x$ conductors are designated "word conductors". In operation of such a ROM the clocking signals $\phi$ are applied to the gates of all the P-channel devices and the common N-channel device so that when the P-channel devices are made conductive the bit lines are given a potential relative to ground or the reference potential. When the common N-channel device is made conductive the ground lines are connected to ground (or reference potential) whereupon those bit lines which are connected to ground lines via short-circuit elements rendered conductive by signals on the respective word lines are grounded, thus losing the potential which they were given. Those bit lines are not so grounded because none of the short-circuit elements connecting them to ground lines are rendered conductive, keep their potential.

A ROM is generally accompanied by a translator or decoder which is operative to select word conductors during operation. A decoder generally itself includes a read-only memory, but in the following parts of this description the expression "ROM" will be used to denote the memory accompanying the decoder as distinct from the memory included in the decoder. In integrated circuit arrangements, the decoder and ROM are formed as part of a single integrated circuit where the decoder is of a form similar to the ROM but turned 90° with respect thereto with metallic "bit conductors" therein electrically connected to polysilicon word conductors of the ROM.

In a microprocessor, the decoder and ROM structures are sometimes also used as a logic array operative to control various other logic circuits defined in a single semiconductor chip. Electrical conductors connecting the bit conductors of the ROM in prior art arrangements are gathered for external connection, at one end of the bit conductors, into a communication path (bus) which follows along the better part of two sides of the ROM occupying a considerable area of the chip.

In microprocessors and most ROM structures it is important to conserve chip area and use it as efficiently as possible, and it is to this problem that the invention is addressed.

The invention as claimed makes use of the fact that in most read-only memory programs the pattern of elements representing the information stored in the read-only memory will be such that a number of the conductors of one of the sets (x or y) can be foreshortened. For example in the type of read-only memory exemplified above there will be a number of stored words which end in a string of binary ones. Since a binary one corresponds to the absence of a short-circuit element no elements are required at cross points corresponding to the terminal string and the corresponding word line can be foreshortened so that no such cross points are in fact formed. With other logic types it may be a string of zeroes which allows foreshortening.

This foreshortening of conductors makes available space which can be used in a variety of ways. For example a ROM usually has many more word conductors than bit conductors, so there will most often be a number of foreshortenable word conductors which is comparable with the total number of bit conductors. Accordingly electrical connections to the bit conductors (or most of them) can be made in the space made available by foreshortening of word conductors. This can considerably reduce the chip area required for connections to the ROM. Alternatively or in addition it may be possible to arrange the information in a read-only memory so that there is an area in one corner of the memory in which no elements are required thus allowing both x and y conductors to be foreshortened, leaving the area free for use by other functional units.

Embodiments of the invention will now be described by way of example with reference to the accompanying drawings, of which:

FIG. 1 is a block diagram of a portion of an integrated circuit microprocessor;

FIG. 2 is a schematic diagram of a ROM and decoder for the logic array of the microprocessor of FIG. 1; and

FIG. 3 is a cross sectional diagram of an element of the ROM of FIG. 2.

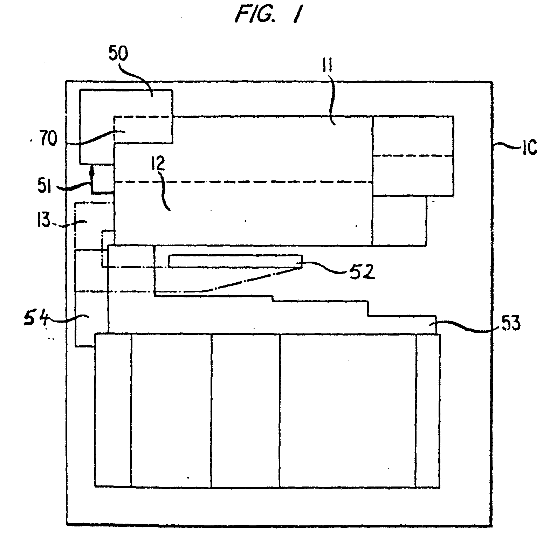

Fig. 1 shows a block diagram of an integrated circuit chip IC operative as a microprocessor. The chip includes a logic array comprising a decoder 11 and a ROM 12. Both the decoder and the ROM are well understood elements and are not discussed in full detail herein. Rather, the elements and the organisation thereof are represented schematically in order to illustrate the topological nature of the invention and the advantages thereof.

The block diagram of the figure is representative of the space utilisation of an integrated circuit. The figure shows, in phantom, an area 13 which would be occupied normally by lead connections to bit conductors in accordance with prior art teachings. It is this area which is saved when the word conductors of a logic array terminate at an intersection with bit conductor at which a short circuit element to ground occurs and beyond which no further short circuit elements are required.

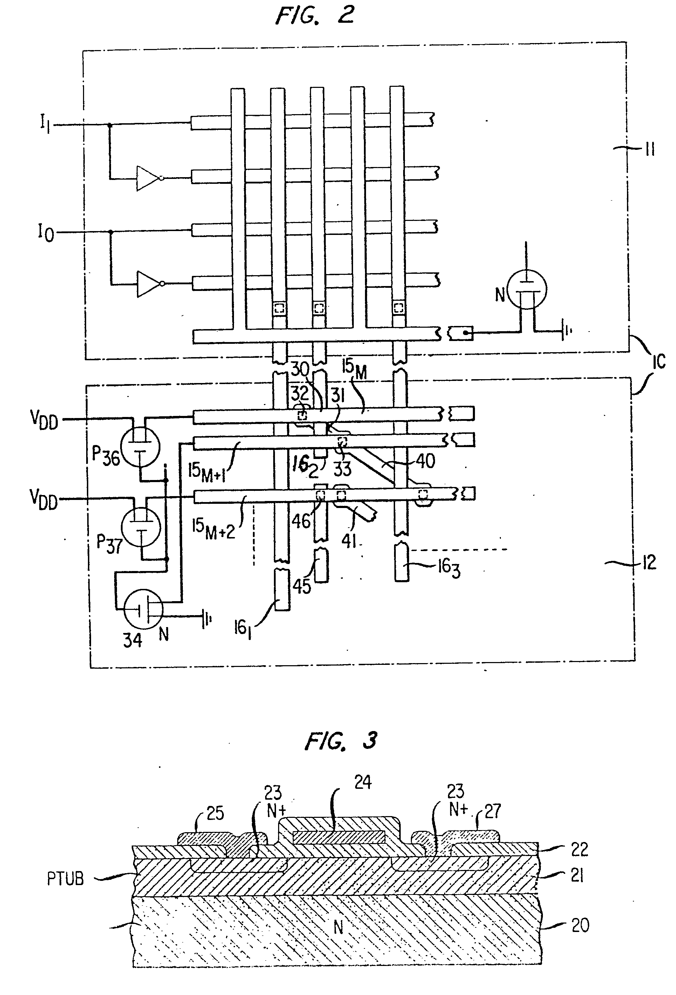

FIG. 2 shows, schematically, the organisation of the PLA in FIG. 1. The ROM comprises alternating bit conductors $15_M$, $15_{M+2}$ ... and ground lines $15_{M+1}$ ... extending horizontally as viewed in the figure, with intersecting word conductors. The word conductors are designated $16_1$, $16_2$, $16_3$ ... and extend vertically as viewed in the figure. The word conductors are formed typically of polysilicon material in a plane or level adjacent the semiconductor layer. The polysilicon layer is coated with an insulating layer in preparation for a second level of metal from which the bit conductors and ground lines are formed. The bit conductors and the word conductors intersect to form cross points at which short-circuit elements in the form of MOS devices are selectively placed to incorporate information as is well understood.

FIG. 3 shows a cross section of an MOS device formed at such an intersection. A typical construction employs an N-type silicon substrate 20 on which a P-type (TUB) layer 21 is formed typically by diffusion. An oxide layer 22 is patterned to define diffused N-type regions 23. A polysilicon word conductor is represented at 24 and a metallic bit conductor is represented at 25. The corresponding ground line is represented at 27.

The short-circuit elements are provided at predetermined ones of the cross points in a well understood manner. For example, at cross point 30 in FIG. 2, short circuit element 31 connects bit conductor $15_M$ at opening 32 in the oxide layer. Element 31 also connects ground line $15_{M+1}$ at opening 33. Because of the short circuit element, when a signal is applied to word conductor $16_2$, bit conductor $15_M$ is grounded through element 34, ground line $15_{M+1}$, and (now closed) N-channel device 31. The pattern of short circuit elements determines which bit conductors remain at the potential to which they are raised by the application of the supply voltage $V_{DD}$ when signal $\phi$ is applied to the P-channel devices P36 and P37, and which bit conductors are grounded.

Read out of the memory occurs in response to a signal applied to a word conductor (i.e., the word conductor goes to a high potential). This may be understood from the representative cross section view of FIG. 3. Consider the polysilicon word conductor 24 of FIG. 3 to correspond to the word conductor $16_2$ of FIG. 2 and bit conductor 25 and ground line 27 of FIG. 3 to correspond to bit conductor $15_M$ and ground line $15_{M+1}$ of FIG. 2. A signal on word conductor $16_2$ then would produce a conducting channel between the N+ regions 23 of FIG. 3. In the absence of an N-channel MOS device at 31, an output signal is observed on bit conductor $15_M$. Because of the presence of element 31 no signal occurs. It is clear then that the pattern of short circuit elements determines the output of the ROM.

The selection of word conductors for a read operation is determined by the decoder portion 11 of the logic array. This determination, as well as the organisation of the decoder, is well understood in the art and not discussed further herein.

What is important for an understanding of the invention is that the pattern of bit conductors and word conductors defines cross points and that the pattern of short circuit elements associated with those cross points determines the information stored by the ROM. Such a ROM is characterised by a number of short circuit elements associated with any particular word conductor. That is to say, if we look along a given word conductor of a ROM, we will find a number of short circuit elements associated with the cross points defined along that word conductor. For example, in FIG. 2 elements 40 and 41 are associated with cross points defined along word line $16_3$. Similarly, a number of short circuit elements can be understood to be associated with word line $16_2$ with element 31 being taken as the last such element associated with cross point 30. Word conductor $16_2$ is terminated at cross point 30 leaving free the space in the polysilicon layer underlying bit conductor $15_{M+2}$ and other ground lines and bit conductors (not shown) therebelow as viewed. It is this free space which is used to make lead connections to the bit conductors.

This foreshortening of word conductor lengths from the lengths that they would ordinarily have makes available space in the polysilicon level to form lead connections to the bit conductors as is represented by element 45 in FIG. 2. Electrical connection is made to the bit conductors by means of aperture 46 in the insulating layer between the word and bit conductor levels.

A typical ROM has perhaps 150 word conductors and 27 bit conductors. A certain number of bit conductors are connected to other functional elements of an integrated circuit chip from the end merely because a functional element occupies a position in the chip at the end of the ROM. One such element is the timing unit shown as Block 50 in FIG. 1. The bit conductor connections are indicated at 51 in FIG. 1 and may represent six of the 27 bit conductors connections. The area in FIG. 1 designated 13 is the area which would be occupied by lead connections to functional elements such as the latches 52, the decoder 53 and a further timing unit 54. Area 13 represents twenty-one of the bit conductor connections of our illustrative ROM. Since each connection requires perhaps 15 microns, area 13 is 21 times 15 microns wide by an average of about 2200 microns long or an area of 693,000 square microns. This area is saved by the foreshortening of the word conductors in the ROM, freeing space in the polysilicon level for electrical conductors connecting the bit conductors from the side of the ROM. Blocks 52, 53 and 54 as well as an interconnect area, are shown occupying space formerly occupied by bit conductor connections.

In the illustrative ROM, twenty-one word conductors would need to be foreshortened to free space for connecting twenty-one of the twenty-seven bit conductors for side connection. The pattern of information in the memory determines which word conductors can be foreshortened. If we adopt the usual convention that a short circuit element represents a binary zero and the absence of such an element represents a binary one, then the occurrence of any terminal string of ones in a word is permissive of the foreshortening of the corresponding word conductor. In a group of 150 word conductors, the probability of a terminal string of ones occurring approaches one.

Typically, the information pattern is such that the foreshortened word conductors have an apparently random distribution in the ROM. The appearance in a photographic blowup of the ROM is something reminiscent of runs in silk stockings. But information can be organised so that all the strings of ones can be collected into a single area. Although such collection into a single area is not particularly important to make contact to bit conductors as in the ROM 12, it is used to advantage in the decoder 11. The information in the decoder 11 is arranged so that there is an area 70 at the upper left hand corner of the decoder 11 as seen in FIG. 1, in which no short-circuit elements are required. Both the $x$ conductors and the $y$ conductors are foreshortened so as to leave the area 70 free to be used by another functional element, in this case the timing unit 50.

## Claims

1. A semiconductor integrated-circuit read-only memory including a set of input conductors ($16_1$, $16_2$, $16_3$) and a set of output conductors ($15_M$, $15_{M+2}$) arranged to define an array of cross points (30), each of the cross points being formed by one input conductor and one output conductor, and elements (31, 40, 41) associated with selected ones of the cross points to provide predetermined patterns of binary signals on the output conductors in response to signals on respective ones of the input conductors, the presence of an element associated with a cross point being representative of a stored binary digit of one kind and the absence of an element associated with a cross point being representative of a stored binary digit of the opposite kind characterised by a subset of conductors ($16_2$) in one said set which are foreshortened so that they do not form cross points with all of the conductors of the other set, such absence of a cross point being representative of a stored binary digit of the said opposite kind, space made available by the said foreshortening being utilised by contact leads (45) to conductors of the said other set.

2. A memory as claimed in claim 1 wherein the input and the output conductors are formed at two different respective levels in the integrated circuit characterised in that the contact leads are formed from the same material as the conductors of the said one of the sets.

3. A memory as claimed in claim 1 or claim 2 wherein the input and the output conductors are formed from two different respective materials characterised in that the contact leads are formed from the same material as the conductors of the said one of the sets.

4. A semiconductor integrated-circuit read-only memory including a set of input conductors ($16_1$, $16_2$, $16_3$) and a set of output conductors ($15_M$, $15_{M+2}$) arranged to define an array of cross points (30), each of the cross points being formed by one input conductor and one output conductor, and elements (31, 40, 41) associated with selected ones of the cross points to provide predetermined patterns of binary signals on the output conductors in response to signals on respective ones of the input conductors, the presence of an element associated with a cross point being representative of a stored binary digit of one kind and the absence of an element associated with a cross point being representative of a stored binary digit of the opposite kind characterised by a subset of conductors ($16_2$) in one said set which are foreshortened so that they do not form cross points with all of the conductors of the other set, such absence of a cross point being representative of a stored binary digit of the said opposite kind and by a plurality of conductors in the other set which are also foreshortened, the sets of conductors being arranged so that there is formed an area (70) clear both of conductors of the said one of the sets and of conductors of the other set.

5. A logic array comprising a decoder (11) having output conductors connected to input conductors ($16_1$, $16_2$, $16_3$) of a read-only memory (12) characterised in that the read-only memory is as claimed in any of claims 1 to 3, the said one of the sets being the set of input conductors, and the decoder includes a further read-only memory as claimed in claim 4.

**Patentansprüche**

1. Integrierter Halbleiter-Festwertspeicher mit einer Gruppe von Eingangsleitern ($16_1$, $16_2$, $16_3$) und einer Gruppe von Ausgangsleitern ($15_M$, $15_{M+2}$), die eine Anordnung von je durch einen Eingangs- und einen Ausgangsleiter gebildeten Kreuzpunkten (30) definieren, sowie mit Elementen (31, 40, 41), die zur Bereitstellung vorbestimmter Binärsignalmuster auf den Ausgangsleitern abhängig von Signalen auf entsprechenden Eingangsleitern gewählten Kreuzhandensein eines einem Kreuzpunkt zugeordneten Elementes eine gespeicherte Binärziffer einer Art und die Abwesenheit eines einem Kreuzpunkt zugeordneten Elementes eine gespeicherte Binärziffer der entgegengesetzten Art darstellen, gekennzeichnet durch eine Untergruppe von Leitern ($16_2$) in einer Gruppe, die verkürzt sind, so daß sie nicht mit allen Leitern der anderen Gruppe Kreuzpunkte bilden, daß dieses Fehlen eines Kreuzpunktes eine gespeicherte Binärziffer der entgegengesetzten Art darstellt und daß durch die Kürung verfügbar gemachter Platz durch Kontaktleitungen (45) zu Leitern der anderen Gruppe ausgenutzt wird.

2. Speicher nach Anspruch 1, bei dem die Eingangs- und die Ausgangsleiter auf zwei verschiedenen Ebenen in der integrierten Schaltung gebildet sind, dadurch gekennzeichnet, daß die Kontaktleitungen auf der gleichen Ebene wie die Leiter der einen Gruppe hergestellt sind.

3. Speicher nach Anspruch 1 oder 2, bei dem die Eingangs- und die Ausgangsleiter aus zwei unterschiedlichen Materialien gebildet sind, dadurch gekennzeichnet, daß die Kontaktleitungen aus dem gleichen Material wie die Leiter der einen Gruppe hergestellt sind.

4. Integrierter Halbleiter-Festwertspeicher mit einer Gruppe von Eingangsleitern ($16_1$, $16_2$, $16_3$) und einer Gruppe von Ausgangsleitern ($15_M$, $15_{M+2}$), die eine Anordnung von je durch einen Eingangs- und einen Ausgangsleiter gebildeten Kreuzpunkten (30) definieren, sowie mit Elementen (31, 40, 41), die zur Bereitstellung vorbestimmter Binärsignalmuster auf den Ausgangsleitern abhängig von Signalen auf entsprechenden Eingangsleitern gewählten Kreuzpunkten zugeordnet sind, wobei das Vorhandensein eines einem Kreuzpunkt zugeordneten Elementes eine gespeicherte Binärziffer einer Art und die Abwesenheit eines einem Kreuzpunkt zugeordneten Elementes eine gespeicherte Binärziffer der entgegengesetzten Art darstellen, gekennzeichnet durch eine Untergruppe von Leitern ($16_2$) in einer Gruppe, die verkürzt sind, so daß sie nicht mit allen Leitern der anderen Gruppe Kreuzpunkte bilden, daß dieses Fehlen eines Kreuzpunktes eine gespeicherte Binärziffer der entgegengesetzten Art darstellt, und durch eine Vielzahl von ebenfalls verkürzten Leiten in der anderen Gruppe, wobei die Gruppen von Leitern so angeordnet sind, daß sie einen Bereich (70) bilden, der frei sowohl von Leitern der einen als auch von Leitern der anderen Gruppe ist.

5. Logikanordnung mit einem Decoder (11) mit Ausgangsleitern, die mit Eingangsleitern ($16_1$, $16_2$, $16_3$) eines Festwertspeichers (12) verbunden sind, dadurch gekennzeichnet, daß der Festwertspeicher nach einem der Ansprüche 1 bis 3 ausgebildet ist, daß die eine der Gruppen die Gruppe von Eingangsleitern ist und daß der Decoder einen weiteren Festwertspeicher gemäß Anspruch 4 aufweist.

**Revendications**

1. Mémoire morte à semiconducteurs et à circuit intégré comportant un jeu de conducteurs d'entrée ($16_1$, $16_2$, $16_3$) et un jeu de conducteurs de sortie ($15_M$, $15_{M+2}$) agencés de manière à définir un groupement de points de croisement (30) dont chacun est formé par un conducteur d'entrée et par un conducteur de sortie, et des éléments (31, 40, 41) associés à des points de croisement sélectionnés fournissant des motifs prédéterminés de signaux binaires sur les conducteurs de sortie en réponse à des signaux sur respectivement des conducteurs d'entrée donnés, la présence d'un élément associé à un point de croisement étant représentatif d'un chiffre binaire mémorisé d'un genre et l'absence d'un élément associé à un point de croisement étant représentatif d'un chiffre binaire mémorisé du genre opposé, caractérisée par un sous-jeu de conducteurs dans l'un desdits jeux et qui sont raccourcis de manière à ne pas former des points de croisement avec tous les conducteurs de l'autre jeu, ladite absence d'un point de croisement étant représentatif d'un chiffre binaire mémorisé dudit genre opposé, l'espace rendu disponible par ledit raccourcissement étant utilisé par des fils de contact (45) avec les conducteurs dudit autre jeu.

2. Mémoire selon la revendication 1, dans laquelle les conducteurs d'entrée et de sortie sont formés respectivement à deux niveaux différents dans le circuit intégré, caractérisée par le fait que les fils de contact sont formés au même niveau que les conducteurs dudit jeu parmi les jeux de conducteurs.

3. Mémoire selon la revendication 1 ou 2, dans laquelle les conducteurs d'entrée et de sortie sont formés respectivement avec deux matériaux différents, caractérisée par le fait que les fils de contact sont formés avec le matériau avec lequel sont formés les conducteurs dudit jeu parmi les jeux de conducteurs.

4. Mémoire morte à semiconducteurs et à circuit intégré comportant un jeu de conducteurs d'entrée ($16_1$, $16_2$, $16_3$) et un jeu de conducteurs de sortie ($15_M$, $15_{M+2}$) agencés de manière à définir un groupement de points de croisement (30) dont chacun est formé par un conducteur d'entrée et par un conducteur de sortie, et des éléments (31, 40, 41) associés à des points de croisement sélectionnés fournissant des motifs de signaux binaires sur les conducteurs de sortie en réponse à des signaux sur respectivement des conducteurs d'entrée donnés, la présence d'un élément associé à un point de croisement étant représentatif d'un chiffre binaire mémorisé d'un genre et l'absence d'un élément associé à un point de croisement étant représentatif d'un chiffre binaire mémorisé du genre opposé, caractérisée par un sous-jeu de conducteurs ($16_2$) dans l'un desdits jeux, raccourcis de manière à ne pas former des points de croisement avec tous les conducteurs de l'autre jeu, l'absence d'un tel point de croisement étant représentatif d'un chiffre binaire dudit genre opposé, et par une pluralité de conducteurs dans l'autre jeu qui sont également raccourcis, les jeux de conducteurs étant disposés de manière que soit formée une zone (70) dépourvue à la fois de conducteurs de l'un desdits jeux et de conducteurs de l'autre jeu.

5. Arrangement logique comportant un décodeur (11) ayant des conducteurs de sortie reliés à des conducteurs d'entrée ($16_1$, $16_2$, $16_3$) d'une mémoire morte (12), caractérisé par le fait que la mémoire morte est telle que revendiquée dans l'une quelconque des revendications 1 à 3, ledit jeu parmi les jeux de conducteurs étant le jeu de conducteurs d'entrée et le décodeur comportant une seconde mémoire morte telle que revendiquée à la revendication 4.

## FIG. 1

## FIG. 2

## FIG. 3